Europäisches Patentamt

European Patent Office

Office européen des brevets

(19)

(11) Veröffentlichungsnummer: **0 303 046 B1**

(12) **EUROPÄISCHE PATENTSCHRIFT**

(45) Veröffentlichungstag der Patentschrift: **02.01.92**

(21) Anmeldenummer: **88110767.6**

(22) Anmeldetag: **06.07.88**

(51) Int. Cl.⁵: **H01L 29/74**, H01L 29/06, H01L 29/10, H01L 29/36, H01L 21/225

(54) **Gate-Turn-Off-Thyristor.**

(30) Priorität: **11.08.87 CH 3096/87**

(43) Veröffentlichungstag der Anmeldung: **15.02.89 Patentblatt 89/07**

(45) Bekanntmachung des Hinweises auf die Patenterteilung: **02.01.92 Patentblatt 92/01**

(84) Benannte Vertragsstaaten: **BE CH DE FR GB IT LI NL SE**

(56) Entgegenhaltungen:
**EP-A- 0 039 509**
**EP-A- 0 216 954**
**DE-A- 2 812 658**
**GB-A- 2 033 154**

**PATENT ABSTRACTS OF JAPAN, Band 5, Nr. 66 (E-55)[738], 2. Mai 1981; & JP-A-56 17 068**

**PATENT ABSTRACTS OF JAPAN, Band 7, Nr. 239 (E-206)[1384], 25. Oktober 1983; & JP-A-58 128 765**

(73) Patentinhaber: **BBC Brown Boveri Aktiengesellschaft**

**CH-5401 Baden(CH)**

(72) Erfinder: **Roggwiller, Peter, Dr.**
**Püntstrasse 16**
**CH-8173 Riedt-Neerach(CH)**
Erfinder: **Vlasak, Thomas**
**Adelmatt 336**
**CH-5242 Birr(CH)**
Erfinder: **Voboril, Jan**
**Landschreiberstrasse 2**
**CH-5415 Nussbaumen(CH)**

IEEE TRANSACTIONS ON ELECTRON DEVICES, Band ED-23, Nr. 8, August 1976, Seiten 956-960, IEEE, New York, US; M.S. ADLER et al.: "A general method for predicting the avalanche breakdown voltage of negative bevelled devices"

INTERNATIONAL JOURNAL OF ELECTRONICS, Band 54, Nr. 1, 1983, Seiten 127-137, Taylor & Francis Ltd, London, GB; V.P. SUNDERSINGH et al.: "Concentration profiling for high voltage $p+$-n-$n+$ diodes"

5th INTERNATIONAL COLLOOUIUM ON PLASMAS AND SPUTTERING, Antibes, 10.-14. Juni 1985, Seiten 89-92; J. VOBORIL et al.: "Effects of in-situ Ar-ion milling on the diffusion homogeneity of Al into Si from thin, sputtered films4

IEEE ELECTRON DEVICE LETTERS, Band EDL-1, Nr. 10, Oktober 1980, Seiten 203-205, IEEE, New York, US; M. AZUMA et al.: "Anode current limiting effect of high power GTOs"

## Beschreibung

### Technisches Gebiet

Die vorliegende Erfindung bezieht sich auf das Gebiet der Leistungshalbleiter. Sie betrifft insbesondere einen Gate-Turn-Off-Thyristor für hohe Sperrspannungen, umfassend
- in einem Halbleitersubstrat zwischen einer Anode und einer Kathode eine p-Emitterschicht, eine n-Basisschicht, eine p-Basisschicht und eine kathodenseitige Gate-Kathodenstruktur; und
- am Substratrand eine Anschrägung zur Verringerung der Oberflächenfeldstärke.

Die Erfindung betrifft weiterhin ein Verfahren zur Herstellung eines solchen Gate-Turn-Off-Thyristors.

### Stand der Technik

Damit ein planarer pn-Uebergang in einem Halbleiterbauelement, beispielsweise einem Hochleistungs-Thyristor, hohe Spannungen (> 1000 V) sperren kann, müssen im Randbereich des scheibenförmigen Bauelementsubstrats besondere Massnahmen getroffen werden, um die hier auftretende Feldstärkeüberhöhung zu reduzieren.

Bekannte Massnahmen bestehen im wesentlichen in einer lateralen Strukturierung der Dotierzonen, und zwar entweder als äussere Konturierung durch Abschleifen oder Ausätzen (positive, negative Anschrägung; Grabenätzung; Mesaätzung oder Substratätzung; siehe dazu V.P. Sundersingh und A.A. Ghatol, Int. J. Electronics, Vol. 54, No. 1 (1983), S. 127-137), oder durch Einbringen spezieller Dotierungsstrukturen (z.B. in Form von sog. "Guard"-Ringen).

Bei Gate-Turn-Off(GTO)-Thyristoren kleinerer Leistung hat sich als Randkonturierung eine einfache Grabenätzung bewährt, die den ansonsten planaren pn-Uebergang zwischen p-Basisschicht und n-Basisschicht unterbricht (siehe dazu: Brown Boveri Technik, 9 (1986), S. 519-525).

Es ist weiterhin bekannt, bei den ganz anders aufgebauten feldgesteuerten Thyristoren als Randkontur einen Doppelgraben vorzusehen, der eine Kombination aus Mesa- und Grabenätzung darstellt (EP-A2 0 178 387). Um für den Doppelgraben genügend Raum zu schaffen, geht am Rand der sehr dünne (5 $\mu$m) und nur gering p-dotierte ($10^{16}$ cm$^{-3}$) Gatebereich in einen tiefergezogenen Randbereich über, der beispielsweise durch die aus der EP-A2 0 216 954 bekannte selektive Aluminiumdiffusion in das Halbleitersubstrat eingebracht werden kann.

Für die Randkonturierung hochsperrender GTO-Thyristoren sind bislang keine detaillierten Lösungen angegeben worden. So ist in der Druckschrift IEEE Trans. Electron Devices, Vol. ED-28, No. 3 (1981), S. 270-274 lediglich ein GTO-Thyristor mit einer Sperrspannung von 2500 V beschrieben worden, dessen Ränder durch Sandstrahlen angeschrägt worden sind. Es werden jedoch in dieser Druckschrift weder Angaben zum lateralen Dotierungsprofil der p-Basisschicht gemacht, noch wird darauf eingegangen, welche Art (positiv oder negativ), Form und Lage diese Anschrägung hat.

Eine besonders einfache, kostengünstige und mit der Druckkontaktierung kompatible Lösung stellt das keilförmige Anschleifen des Scheibenrandes unter einem kleinen negativen Winkel (die o.g. negative Anschrägung) dar. Eine ausreichende Reduktion der elektrischen Feldstärke am Rand ist mit dieser Technologie aber nur möglich, wenn entweder der Anschrägungswinkel extrem klein ist ($\approx$ 1$^{\circ}$) oder der sperrende pn-Uebergang nicht zu stark asymmetrisch ist (Dicke des pn-Uebergangs > 70 $\mu$m; Dotierungskonzentration am Rand des p-Profils < 5 $\cdot$ 10$^{17}$ cm$^{-3}$)

Eine Anwendung der negativen Anschrägung auf hochsperrende GTO-Thyristoren mit planarem pn-Uebergang würde daher folgendes Problem aufwerfen: Die p-Basisschicht dieser Bauelemente muss sowohl hochdotiert (Rand-Dotierungskonzentration $N_{po}$ > $10^{18}$ cm$^{-3}$) sein, als auch eine geringe Dicke bzw. Tiefe haben (Eindringtiefe der p-Basisschicht $X_{Jp}$ < 70 $\mu$m).

Eine ausreichende Reduzierung der Randfeldstärke würde dann nur mit den o.g. kleinen Anschrägungswinkeln zu erreichen sein. Solche kleinen Anschrägungswinkel erfordern jedoch einen breiten Randbereich und damit einen Verlust an aktiver Fläche. Darüber hinaus sind sie nur schwer mit der nötigen Präzision herzustellen.

Ein GTO-Thyristor mit dickerer, negativ angeschrägter p-Basisrandschicht ist aus JP-A-56 17068 bekannt.

### Darstellung der Erfindung

Aufgabe der vorliegenden Erfindung ist es nun, einen hochsperrenden GTO-Thyristor sowie ein Verfahren zu dessen Herstellung anzugeben, bei dem durch eine geeignete Anschrägung die Randfeldstärke sicher und einfach auf das erforderliche Mass reduziert werden kann.

Die Aufgabe wird bei einem GTO-Thyristor der eingangs genannten Art dadurch gelöst, dass
- die p-Basisschicht unterteilt ist in eine zentrale p-Basisschicht und eine p-Basis-Randschicht, welche die p-Basis-schicht umgibt,
- der Aktivteil des Thyristors im Bereich der zentralen p-Basisschicht angeordnet ist,
- die p-Basis-Randschicht eine grössere Dicke aufweist als die zentrale p-Basisschicht,

- die p-Basis-Randschicht eine geringere Dotierungskonzentration aufweist als die zentrale p-Basisschicht,
- die Anschrägung als negative Anschrägung ausgebildet ist,
- die negative Anschrägung im Bereich der p-Basis-Randschicht angeordnet ist, und
- den durch die p-Basis-Randschicht und n-Basisschicht gebildeten pn-Uebergang schneidet.

Der Kern der Erfindung besteht darin, hinsichtlich der p-Basisschicht den zentralen Bereich mit dem Aktivteil und den Randbereich zu entkoppeln, so dass die entstehende p-Basis-Randschicht im Hinblick auf die Randanschrägung ohne Rücksicht auf den Aktivteil optimal ausgestaltet werden kann. Auf diese Weise kann eine negative Anschrägung trotz der schwierigen Verhältnisse beim hochsperrenden GTO-Thyristor mit grossem Erfolg eingesetzt werden.

Gemäss einer bevorzugten Ausführungsform der Erfindung hat der GTO-Thyristor eine Sperrspannung von mehr als 3000 V, eine Dotierungskonzentration am Rande der zentralen p-Basisschicht von mehr als $10^{18}$ cm$^{-3}$, eine Dotierungskonzentration am Rande der p-Basis-Randschicht von weniger als $5 \cdot 10^{17}$ cm$^{-3}$, eine Dicke der zentralen p-Basisschicht kleiner als 70 $\mu$m, und eine Dicke der p-Basisschicht grösser als 90 $\mu$m.

Das erfindungsgemässe Verfahren umfasst die folgenden Schritte:
- in das n-dotierte Halbleitersubstrat wird auf der Kathodenseite im Randbereich eine erste Prädepositionsschicht mit einem Akzeptormaterial hoher Diffusionskonstante eingebracht;
- in das n-dotierte Halbleitersubstrat wird auf der Kathodenseite zumindest im zentralen Bereich eine zweite Prädepositionsschicht mit einem Akzeptormaterial geringer Diffusionskonstante eingebracht;
- in einem nachfolgenden Diffusionsschritt werden von beiden Prädepositionsschichten aus die Akzeptoren gleichzeitig in das Halbleitersubstrat eindiffundiert; und
- nach Fertigstellung der übrigen Struktur des Thyristors wird die negative Anschrägung am Substratrand angebracht.

Gemäss einem bevorzugten Ausführungsbeispiel des erfindungsgemässen Verfahrens wird als Akzeptormaterial für die erste Prädespositionsschicht Aluminium, und für die zweite Prädepositionsschicht Bor verwendet.

Weitere Ausführungsbeispiele der Erfindung ergeben sich aus den Unteransprüchen.

Kurze Beschreibung der Zeichnung

Die Erfindung soll nachfolgend anhand von Ausführungsbeispielen im Zusammenhang mit der Zeichnung näher erläutert werden. Es zeigen:

Fig. 1A-D verschiedene Stufen bei der Herstellung eines beispielhaften GTO-Thyristors nach der Erfindung; und

Fig. 2 die berechnete Feldstärkeverteilung für eine GTO-Struktur gemäss einem Ausführungsbeispiel der Erfindung.

Wege zur Ausführung der Erfindung

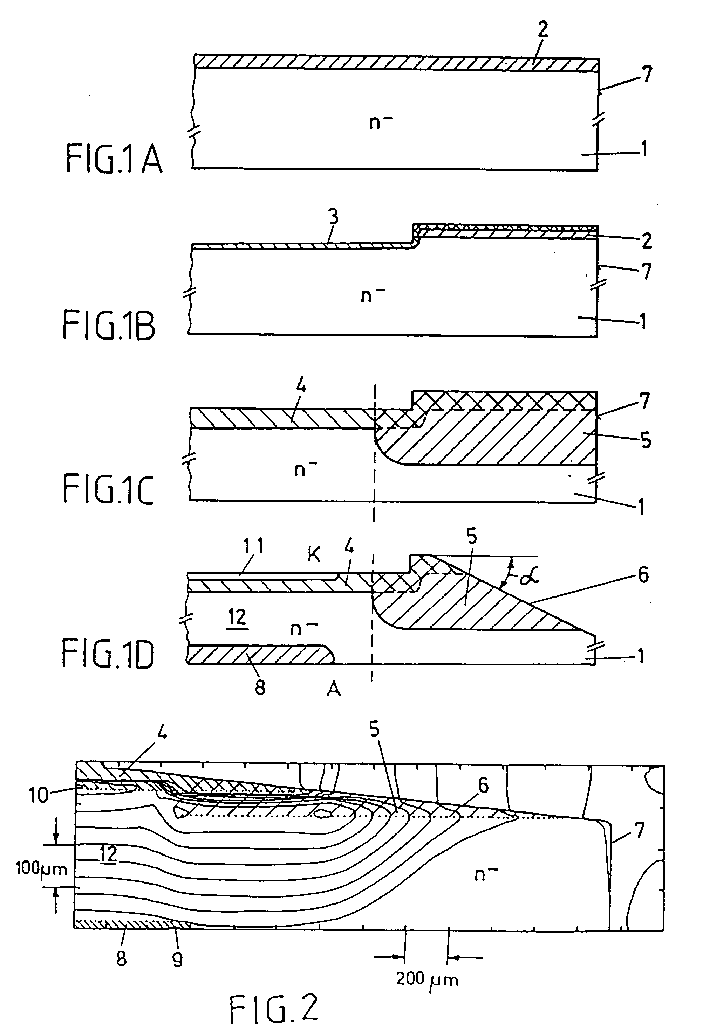

In den Fig. 1A-D ist ausschnittsweise der Randbereich und ein kleiner Teil des zentralen Bereichs im Querschnitt für einen beispielhaften GTO-Thyristor nach der Erfindung in verschiedenen Herstellungsstufen wiedergegeben. Auf eine detaillierte Darstellung des Thyristor-Aktivteils im zentralen Bereich ist dabei aus Gründen der Uebersichtlichkeit verzichtet worden.

Der Aufbau des fertigen Thyristors ist in Fig. 1D gezeigt. Er beteht aus einem Halbleitersubstrat 1 mit schwacher n-Grunddotierung. Zwischen einer Anode A und einer Kathode K sind nacheinander eine p-Emitterschicht 8, eine n-Basisschicht 12, eine p-Basisschicht und eine Gate-Kathodenstruktur 11 angeordnet.

Die p-Basisschicht teilt sich auf in eine zentrale p-Basisschicht 4, die im zentralen Bereich (links der gestrichelten Senkrechten) des Thyristors liegt, und eine p-Basis-Randschicht 5, die im Randbereich (rechts der gestrichelten Senkrechten) des Thyristors angeordnet ist.

Die p-Basis-Randschicht 5 ragt tiefer in das Halbleitersubstrat 1 hinein als die zentrale p-Basisschicht 4. Im Bereich der p-Basis-Randschicht 5 ist auf der Oberseite des Halbleitersubstrats 1 eine negative Anschrägung 6 mit einem Anschrägungswinkel angebracht (negativ heisst die Anschrägung, wenn die horizontale Querschnittsfläche des Substrats von der höher dotierten zur niedriger dotierten Schicht zunimmt).

Die Dicke der zentralen p-Basisschicht 4, d.h. die von der kathodenseitigen Oberfläche aus gemessene Eindringtiefe ist vorzugsweise kleiner 70 $\mu$m, die entsprechende Dicke der p-Basis-Randschicht 5 dagegen grösser 90 $\mu$m.

Die p-Dotierungskonzentration am Rande der zentralen p-Basisschicht 4 ist vorzugsweise grösser $5 \cdot 10^{17}$ cm$^{-3}$, insbesondere grösser $10^{18}$ cm$^{-5}$, die entsprechende Dotierungskonzentration der p-Basis-Randschicht 5 vorzugsweise kleiner $5 \cdot 10^{17}$ cm$^{-3}$.

Durch die unabhängige Wahl der Parameter Dotierungskonzentration und Eindringtiefe für die p-Basis-Randschicht 5 lässt sich nun erreichen, dass der Anschrägungswinkel $\alpha$ der negativen Anschrägung 6 grösser als 1$^\circ$, insbesondere zwischen 2

und 6°, Z.B. bei 3,5°, eingestellt werden kann. Anschrägungen mit solch grossem Anschrägungswinkel $\alpha$ lassen sich problemlos schleifen und ermöglichen Sperrspannungen grösser 1000 V, insbesondere oberhalb 3000 V.

Eine bevorzugte Art der Herstellung (Fig. 1A-D) geht aus von dem schwach n-dotierten Halbleitersubstrat 1, welches zunächst die Form einer ebenen Scheibe mit einem senkrechten Substratrand 7 hat. In das Halbleitersubstrat 1 wird in herkömmlicher Weise auf der Kathodenseite eine erste Prädepositonsschicht 2 mit einem Akzeptormaterial hoher Diffusionskonstante, vorzugsweise Aluminium, eingebracht (Fig. 1A).

Da speziell Aluminium nicht in geeigneter Weise maskierbar ist, wird die erste Prädespositionsschicht 2 zunächst ganzflächig erzeugt. Im zentralen Bereich des Bauelements wird dann das Siliziummaterial des Halbleitersubstrats 1 so tief angeätzt, bis die erste Prädepositionsschicht 2 in diesem Bereich sicher entfernt ist.

In einem weiteren Schritt wird, wiederum ganzflächig (oder aber nur auf den zentralen Bereich beschränkt) eine zweite Prädepositionsschicht 3 mit einem Akzeptormaterial geringer Diffusionskonstante, vorzugsweise Bor, in das Halbleitersubstrat 1 eingebracht (Fig. 1B). Die Bor-Prädeposition kann dabei vorteilhaft mittels Ionenimplantation vorgenommen werden.

Es schliesst sich ein Diffusionsschritt an, in dem beide Akzeptoren gleichzeitig aus den entsprechenden Prädepositionschichten 2, 3 in das Halbleitersubstrat 1 eindiffundiert werden (drive-in). Das Akzeptormaterial mit der hohen Diffusionskonstante (Al) erzeugt dann eine tieferliegende Dotierungszone (die p-Basis-Randschicht 5) als das Akzeptormaterial (B) mit der geringen Diffusionskonstante (Fig. 1C).

Von dem Zwischenstadium der Fig. 1C ausgehend können nun die übrigen Strukturen in das Bauelement eingebracht werden (z.B. die p-Emitterschicht 8 oder die Gate-Kathodenstruktur 11).

Nachdem die hier nicht dargestellten, üblichen Zwischenprozesse abgeschlossen sind, wird mit Anbringen der negativen Anschrägung 6 durch Sandstrahlen oder Schleifen die in Fig. 1D gezeigte Struktur erreicht. Der Rand des Bauelements kann schliesslich in herkömmlicher Weise passiviert werden.

Für ein ausgewähltes Beispiel des erfindungsgemässen GTO-Thyristors ist zum Nachweis der erreichten Verbesserung die Feldstärkeverteilung berechnet worden. In diesem Beispiel wurde mit folgenden Parametern gerechnet:

anliegende Sperrspannung: 3000 V
Gesamtdicke des GTO: 400 $\mu$m
spez. Widerstand der n-Basisschicht 12: 100 Ohm-cm

Eindringtiefe der zentralen p-Basisschicht 4: 65 $\mu$m
Randkonzentration der zentralen p-Basisschicht 4: 2 $\cdot$ $10^{18}$ cm$^{-3}$
Eindringtiefe der p-Basis-Randschicht 5: 125 $\mu$m
Randkonzentration der p-Basis-Randschicht 5: $10^{16}$ cm$^{-3}$
Anschrägungswinkel $\alpha$: 3,5°

Die aus der Rechnung resultierenden Linien gleicher Feldstärke sind in Fig. 2 dargestellt. Die punktierten Linien geben hier die Grenzen der Dotierzonen an. Die Feldstärke ist, ausgehend von einem Feldstärkeminimum 9 der Grösse 2500 V/cm, in Schritten von 25000 V/cm (Abstand zwischen benachbarten Linien) bis zu einem Feldstärkemaximum 10 mit 185424 V/cm berechnet worden.

Wie man aus der Figur deutlich erkennt, liegt das Feldstärkemaximum nicht im gefährlichen Randbereich, sondern im Aktivteil (zentralen Bereich) der Struktur. Dies besagt, dass selbst mit einem vergleichsweise hohen Anschrägungswinkel von 3,5° bei der erfindungsgemässen Struktur die randseitigen Feldstärken sicher beherrscht werden können.

Insgesamt steht mit der Erfindung ein GTO-Thyristor zur Verfügung, der sich durch einfachen Aufbau, leichte Herstellbarkeit und sichere Beherrschung hoher Sperrspannungen auszeichnet.

**Patentansprüche**

1. Gate-Turn-Off-Thyristor für hohe Sperrspannungen, umfassend
   a) in einem Halbleitersubstrat (1) zwischen einer Anode und einer Kathode eine p-Emitterschicht (8), eine n-Basisschicht (12), eine p-Basisschicht und eine kathodenseitige Gate-Kathodenstruktur (11); und
   b) am Substratrand (7) eine Anschrägung zur Verringerung der Oberflächenfeldstärke;
   dadurch gekennzeichnet, dass
   c) die p-Basisschicht unterteilt ist in eine zentrale p-Basisschicht (4) und eine p-Basis Randschicht (5), welche die zentrale p-Basisschicht (4) umgibt,
   d) der Aktivteil des Thyristors im Bereich der zentralen p-Basisschicht (4) angeordnet ist;
   e) die p-Basis-Randschicht (5) eine grössere Dicke aufweist als die zentrale p-Basisschicht (4);
   f) die p-Basis-Randschicht (5) eine geringere Dotierungskonzentration aufweist als die zentrale p-Basisschicht (4);
   g) die Anschrägung als negative Anschrägung (6) ausgebildet ist;

h) die negative Anschrägung (6) im Bereich der p-Basis-Randschicht (5) angeordnet ist; und

i) den durch p-Basis-Randschicht (5) und n-Basisschicht gebildeten pn-Uebergang schneidet.

2. Gate-Turn-Off-Thyristor nach Anspruch 1, dadurch gekennzeichnet, dass

a) die Sperrspannung grösser als 1000 V, vorzugsweise grösser als 3000 V ist;

b) die Dotierungskonzentration am Rande der zentralen p-Basisschicht (4) grösser als $5 \cdot 10^{17}$ cm$^{-3}$, vorzugsweise grösser als $10^{18}$ cm$^{-3}$ ist;

c) die Dotierungskonzentration am Rande der p-Basis-Randschicht (5) kleiner als $5 \cdot 10^{17}$ cm$^{-3}$ ist;

d) die Dicke der zentralen p-Basisschicht (4) kleiner als 70 $\mu$m ist; und

e) die Dicke der p-Basis-Randschicht (5) grösser als 90 $\mu$m ist.

3. Gate-Turn-Off-Thyristor nach Anspruch 2, dadurch gekennzeichnet, dass die negative Anschrägung (6) einen Anschrägungswinkel ($\alpha$) aufweist, der dem Betrage nach grösser 1°, vorzugsweise zwischen 2° und 6° ist.

4. Gate-Turn-Off-Thyristor nach Anspruch 3, dadurch gekennzeichnet, dass

a) die zentrale p-Basisschicht (4) mit Bor, und

b) die p-Basis-Randschicht (5) im wesentlichen mit Aluminium dotiert sind.

5. Verfahren zum Herstellen eines Gate-Turn-Off-Thyristors nach Anspruch 1, gekennzeichnet durch folgende Schritte:

a) in das n-dotierte Halbleitersubstrat (1) wird auf der Kathodenseite im Randbereich eine erste Prädepositionsschicht (2) mit einem Akzeptormaterial hoher Diffusionskonstante eingebracht;

b) in das n-dotierte Halbleitersubstrat (1) wird auf der Kathodenseite zumindest im zentralen Bereich eine zweite Prädepositionsschicht (3) mit einem Akzeptormaterial geringer Diffusionskonstante eingebracht;

c) in einem nachfolgenden Diffusionsschritt werden von beiden Prädepositionsschichten (2, 3) aus die Akzeptoren gleichzeitig in das Halbleitersubstrat (1) eindiffundiert; und

d) nach Fertigstellung der übrigen Struktur des Thyristors wird die negative Anschrägung (6) am Substratrand (7) angebracht.

6. Verfahren nach Anspruch 5, dadurch gekennzeichnet, dass als Akzeptormaterial für die erste Prädepositionsschicht (2) Aluminium, und für die zweite Prädepositionsschicht (3) Bor verwendet wird.

7. Verfahren nach Anspruch 6, dadurch gekennzeichnet, dass

a) zum Erzeugen der ersten Prädepositionsschicht (2) das Aluminium zunächst ganzflächig in das Halbleitersubstrat (1) eingebracht wird;

b) die entstehende ganzflächige Prädepositionsschicht im zentralen Bereich weggeätzt wird; und

c) anschliessend das Bor ganzflächig in das Halbleitersubstrat (1) eingebracht wird.

8. Verfahren nach Anspruch 7, dadurch gekennzeichnet, dass das Bor mittels Ionenimplantation in das Halbleitersubstrat (1) eingebracht wird.

**Claims**

1. Gate turn-off thyristor for high reverse voltages, comprising:

a) a p-type emitter layer (8), an n-type base layer (12), a p-type base layer and a cathode-side gate-cathode structure (11) in a semiconductor substrate (1) between an anode and a cathode; and

b) a bevelling at the substrate edge (7) to reduce the upper surface field strength; characterised in that

c) the p-type base layer is subdivided into a central p-type base layer (4) and a p-type base edge layer (5) which surrounds the central p-type base layer (4);

d) the active part of the thyristor is disposed in the region of the central p-type base layer (4);

e) the p-type base edge layer (5) has a greater thickness than the central p-type base layer (4);

f) the p-type base edge layer (5) has a lower doping concentration than the central p-type base layer (4);

g) the bevelling is constructed as negative bevelling (6);

h) the negative bevelling (6) is disposed in the region of the p-type base edge layer (5); and

i) cuts the pn junction formed by the p-type base edge layer and the n-type base layer.

2. Gate turn-off thyristor according to Claim 1, characterised in that

a) the reverse voltage is greater than 1000 V, preferably greater than 3000 V;

b) the doping concentration at the edge of the central p-type base layer (4) is greater than $5 \times 10^{17}$ cm$^{-3}$, preferably greater than $10^{18}$ cm$^{-3}$;

c) the doping concentration at the edge of the p-type base edge layer (5) is less than $5 \times 10^{17}$ cm$^{-3}$;

d) the thickness of the central p-type base layer (4) is less than 70 $\mu$m; and

e) the thickness of the p-type base edge layer (5) is greater than 90 $\mu$m.

3. Gate turn-off thyristor according to Claim 2, characterised in that the negative bevelling (6) has a bevelling angle ($\alpha$) which is greater in amount than 1$^\circ$, preferably between 2$^\circ$ and 6$^\circ$.

4. Gate turn-off thyristor according to Claim 3, characterised in that

a) the central p-type base layer (4) is doped with boron,

b) and the p-type base edge layer (5) is essentially doped with aluminium.

5. Process for producing a gate turn-off thyristor according to Claim 1, which is characterised by the following steps:

a) a first predeposition layer (2) containing an acceptor material with a high diffusion constant is introduced into the n-type doped semiconductor substrate (1) on the cathode side in the edge region;

b) a second predeposition layer (3) containing an acceptor material with a low diffusion constant is introduced into the n-type doped semiconductor substrate (1) on the cathode side at least in the central region;

c) in a subsequent diffusion step, the acceptors are simultaneously diffused into the semiconductor substrate (1) from the two predeposition layers (2, 3); and

d) after the remaining structure of the thyristor has been produced, the negative bevelling (6) is provided at the substrate edge (7).

6. Process according to Claim 5, characterised in that aluminium is used as acceptor material for the first predeposition layer (2) and boron for the second predeposition layer (3).

7. Process according to Claim 6, characterised in that

a) to produce the first predeposition layer (2), the aluminium is first introduced over the entire surface into the semiconductor substrate (1);

b) the predeposition layer produced over the entire surface is etched away in the central region; and

c) the boron is then introduced over the entire area into the semiconductor substrate (1).

8. Process according to Claim 7, characterised in that boron is introduced into the semiconductor substrate (1) by means of ion implantation.

**Revendications**

1. Thyristor à commande d'extinction pour des tensions d'arrêt élevées, comprenant

a) dans un substrat semi-conducteur (1) entre une anode et une cathode une couche d'émetteur "p" (8), une couche de base "n" (12), une couche de base "p" et une structure cathode-grille (11) du côté de la cathode; et

b) au bord (7) du substrat un biseau pour diminuer l'intensité du champ superficiel; caractérisé en ce que

c) la couche de base "p" est subdivisée en une couche de base "p" centrale (4) et une couche de base "p" périphérique (5) qui entoure la couche de base "p" centrale (4),

d) la partie active du thyristor est disposée dans la région de la couche de base "p" centrale (4),

e) la couche de base "p" périphérique (5) présente une épaisseur plus grande que la couche de base "p" centrale (4),

f) la couche de base "p" périphérique (5) présente une concentration de dopage moindre que la couche de base "p" centrale (4),

g) le biseau est un biseau négatif (6),

h) le biseau négatif (6) est disposé dans la région de la couche de base "p" périphérique (5), et

i) il coupe la jonction "pn" formée par la couche de base "p" périphérique (5) et la couche de base "n".

2. Thyristor à commande d'extinction suivant la revendication 1, caractérisé en ce que

a) la tension d'arrêt est supérieure à 1000 V, de préférence supérieure à 3000 V;

b) la concentration de dopage au bord de la couche de base "p" centrale (4) est supérieure à $5.10^{17}$ cm$^{-3}$, de préférence supérieure à $10^{18}$ cm$^{-3}$;

c) la concentration de dopage au bord de la couche de base "p" périphérique (5) est inférieure à $5.10^{17}$ cm$^{-3}$;

d) l'épaisseur de la couche de base "p" centrale (4) est inférieure à 70 $\mu$m; et

e) l'épaisseur de la couche de base "p" périphérique (5) est supérieure à 90 $\mu$m.

3. Thyristor à commande d'extinction suivant la revendication 2, caractérisé en ce que le biseau négatif (6) présente un angle de biseau ($\alpha$) qui, suivant sa valeur, est supérieur à 1°, et est de préférence compris entre 2° et 6°.

4. Thyristor à commande d'extinction suivant la revendication 3, caractérisé en ce que

a) la couche de base "p" centrale (4) est dopée au bore, et

b) la couche de base "p" périphérique (5) est dopée essentiellement à l'aluminium.

5. Procédé pour fabriquer un thyristor à commande d'extinction suivant la revendication 1, caractérisé par les opérations suivantes:

a) dans le substrat semi-conducteur (1) à dopage "n" on introduit, du côté de la cathode dans la région du bord, une première couche de prédéposition (2) avec un matériau accepteur ayant une haute constante de diffusion;

b) dans le substrat semi-conducteur (1) à dopage "n" on introduit, du côté de la cathode au moins dans la région centrale, une seconde couche de prédéposition (3) avec un matériau accepteur ayant une constante de diffusion moins élevée;

c) dans une opération de diffusion ultérieure, les accepteurs sont diffusés simultanément dans le substrat semi-conducteur (1) à partir des deux couches de prédéposition (2, 3); et

d) après achèvement du reste de la structure du thyristor, on réalise le biseau négatif (6) au bord (7) du substrat.

6. Procédé suivant la revendication 5, caractérisé en ce que l'on utilise l'aluminium comme matériau accepteur pour la première couche de prédéposition (2) et le bore pour la seconde couche de prédéposition (3).

7. Procédé suivant la revendication 6, caractérisé en ce que

a) pour obtenir la première couche de prédéposition (2), l'aluminium est d'abord introduit sur toute la surface dans le substrat semi-conducteur (1);

b) on attaque dans la région centrale la couche de prédéposition existant sur toute la surface; et

c) on introduit finalement le bore sur toute la surface dans le substrat semi-conducteur (1).

8. Procédé suivant la revendication 7, caractérisé en ce que l'on introduit le bore dans le substrat semi-conducteur (1) par implantation d'ions.

FIG.1A

FIG.1B

FIG.1C

FIG.1D

FIG.2